# EUROPÄISCHE PATENTANMELDUNG

(11) **EP 1 876 872 A1**
(43) Veröffentlichungstag der Anmeldung: **09.01.2008**
(21) Anmeldenummer: 06014089.4
(22) Anmeldetag: 07.07.2006
(51) Int. Cl.: H05K 1/18, H05K 1/00

(54) **Leiterplatte zur Bestückung mit oberflächenmontierten Bauteilen sowie Verfahren dazu**

(71) Anmelder: Delphi Technologies, Inc., Troy, Michigan 48007 (US)
(72) Erfinder: Reischl, Erik, 55765 Birkenfeld (DE); Leng, Peter, 55128 Mainz (DE)
(74) Vertreter: Becker, Bernd

(57) **Zusammenfassung**

Eine Leiterplatte (3) zur Bestückung mit oberflächenmontierten Bauteilen wird gleichzeitig mit einem Stanzgitter (1) versehen, das dreidimensional ausgeformt und von einem Kunststoff (2) ummantelt ist.

## Beschreibung

Die Erfindung bezieht sich auf eine Leiterplatte zur Bestückung mit oberflächenmontierten Bauteilen und ein Verfahren zum Bestücken einer Leiterplatte, bei dem oberflächenmontierte Bauteile auf der Leiterplatte befestigt werden.

Gedruckte Schaltungen oder Leiterplatten werden auf praktisch allen Gebieten der Technik verwendet, um verschiedene Geräte zu steuern oder zu regeln. Auf den Leiterplatten sind unterschiedliche elektrische Bauteile, wie integrierte Schaltkreise, Kondensatoren, Widerstände und dergleichen, angeordnet, wobei diese Bauteile mit elektrisch leitfähigen Kontakten durch Öffnungen der Leiterplatte hindurch gesteckt und verlötet oder verschweißt sind. Dem Fachmann sind starre Leiterplatten sowie flexible Leiterplatten bekannt.

Weiterhin sind aus Metall ausgestanzte Stanzgitter bekannt, mit denen beispielsweise die vorstehend genannten elektrischen Bauteile unmittelbar miteinander verbunden werden können. Ein derartiges Stanzgitter ist in der DE 44 30 798 A1 offenbart. Dieses Stanzgitter verringert den Aufwand zum Verbinden der verschiedenen elektrischen Bauteile erheblich und kann mit einem Kunststoff ummantelt sein, der beispielsweise aufgespritzt oder in das Stanzgitter eingegossen wird.

Des Weiteren ist es bekannt, auf einer festen oder flexiblen Leiterplatte einen miniaturisierten Schalter (micro controller) zum Regeln bzw. Ein- und Ausschalten eines elektrischen Stroms anzuordnen. Dies ist jedoch insofern nachteilig, als durch die unmittelbare Anordnung des Schalters an oder auf der Leiterplatte der Schalter nur eine geringe Stromstärke schalten kann, da beim Hindurchfließen eines stärkeren Stroms der Schalter und/oder die Leiterplatte durch die anfallende Wärmeleistung thermisch beschädigt werden können.

Es ist Aufgabe der Erfindung, eine Leiterplatte der eingangs genannten Art zu schaffen, die mit verschiedenen Bauteilen bestückbar ist, um sie auf unterschiedlichen Gebieten der Technik einsetzen zu können. Des Weiteren soll ein Verfahren zur vereinfachten Bestückung von Leiterplatten angegeben werden.

Erfindungsgemäß wird die Aufgabe bei einer Leiterplatte dadurch gelöst, dass an der Leiterplatte ein von einem Kunststoff ummanteltes und dreidimensional ausgeformtes Stanzgitter angeordnet ist

Die Aufgabe wird bei einem Verfahren zum Bestücken einer Leiterplatte, bei dem oberflächenmontierte Bauteile auf der Leiterplatte befestigt werden, erfindungsgemäß dadurch gelöst, dass ein Stanzgitter, das von einem Kunststoff ummantelt und dreidimensional ausgeformt ist, gleichzeitig auf der Leiterplatte befestigt wird.

Der Kerngedanke der Erfindung besteht darin, ein an sich bekanntes Stanzgitter zur Verbindung verschiedener elektrischer Bauteile selbst dreidimensional auszuformen, das demnach keine im Wesentlichen flächige Ausgestaltung aufweist. Zudem ist das Stanzgitter mit einem hierfür geeigneten Kunststoffmaterial ummantelt oder umhüllt bzw. in einen solchen Kunststoff eingegossen, um eine zusätzliche elektrische und bei geeigneter Wahl des Kunststoffs auch thermische Isolierung zu erhalten. Selbstverständlich sind eventuell benötigte Kontaktflächen oder elektrisch leitfähige Bereiche, die mit anderen Bauteilen oder Schaltern zu verbinden sind, nicht mit dem Kunststoff überzogen. Entsprechende Kunststoffe sind dem Fachmann in Abhängigkeit des gewählten Metalls bzw. der Metalllegierung für das Stanzgitter sowie dem Material der Leiterplatte bekannt.

Ein solches dreidimensional ausgeformtes und mit einem Kunststoff überzogenes Stanzgitter kann gemeinsam mit weiteren elektrischen Bauteilen, so genannten oberflächenmontierten Bauteilen, englisch: surface mounted device, SMD, in einem einzigen Arbeitsgang an oder auf der Leiterplatte befestigt werden. Hierzu wird das dreidimensional ausgeformte Stanzgitter vorzugsweise maschinell an der Leiterplatte positioniert und in gleicher Weise und im gleichen Arbeitsgang wie andere oberflächenmontierte elektrische Bauteile festgelötet oder festgeschweißt. Somit ist der Herstellungsprozess einer Leiterplatte wesentlich vereinfacht, da verschiedene elektrische Bauteile sowie Stanzgitter gleichzeitig montiert werden können.

Selbstverständlich können die mit zusätzlichen Stanzgittern versehene Leiterplatten auf allen Gebieten der Technik eingesetzt werden, beispielsweise in der Mechatronik, um mit Schaltern auf einer festen oder flexiblen Leiterplatte Ströme schalten zu können, wobei die Leiterplatte in MID-Technik (engl. moulded interconnected device) gefertigt sein kann, es also möglich ist, dass es sich um ein räumliches Kunststoffteil mit Leiterbahnen handelt.

Bevorzugt ist das dreidimensional ausgeformte Stanzgitter gehäuseartig ausgebildet, um im Wesentlichen eine gleiche Formgebung wie andere oberflächenmontierte Bauteile aufzuweisen und somit den Herstellungs- bzw. Befestigungsprozess zu vereinfachen. Weiterhin wird mit einem derartigen Stanzgitter erreicht, dass ein weiteres elektrisches Bauteil, das, wie im Folgenden beschrieben, an diesem befestigt wird, von der Leiterplatte selbst beabstandet ist, wodurch insbesondere thermische oder schalttechnische Beschädigungen der Leiterplatte zuverlässig vermieden sind.

Vorteilhafterweise ist an einer Oberfläche des Stanzgitters eine Kontaktfläche ausgebildet, die insbesondere derart ausgelegt ist, dass eine elektrische Verbindung über einen beweglichen Kontaktschieber hergestellt werden kann, wobei der Kontaktschieber derart positioniert ist, dass er in Berührung mit der Kontaktfläche gebracht werden kann. Insbesondere kann eine derartige Kontaktfläche mit einer Beschichtung zur Verbesserung der Kontaktierung zu weiteren elektrischen Bauteilen versehen sein.

In weiterer Ausgestaltung ist das Stanzgitter derart ausgelegt, dass es mit Strömen hoher Stromstärke belastbar ist. Insbesondere kann es hierzu in einer entsprechenden Dicke bzw. mit entsprechenden Querschnitten ausgeführt sein, wobei durch die dreidimensionale Ausgestaltung des Stanzgitters gewährleistet ist, dass die durch das Stanzgitter hindurchfließenden Ströme nicht zu einer thermischen Beschädigung der starren oder flexiblen Leiterplatte führen.

Nach einer Weiterbildung ist das Stanzgitter durch Führungselemente für ein Schiebeschaltglied begrenzt. Zweckmäßigerweise sind den Führungselementen insbesondere einstückig damit ausgebildete Rampen zugeordnet, die mit federnden Kontaktarmen zum Abheben und Aufsetzen auf Kontaktflächen zusammenwirken. Alternativ trägt das Stanzgitter in einem Steckkragen angeordnete Steckkontakte. Vorzugsweise sind die Führungselemente und/oder der Steckkragen aus Kunststoff gefertigt und einstückig mit der Leiterplatte ausgebildet.

Zusätzlich können an dem gehäuseartig ausgeformten Stanzgitter weitere oberflächenmontierte Bauteile angeordnet und/oder kontaktiert werden, um derart über das Stanzgitter diese Bauteile von der Leiterplatte zu beabstanden. Diese Bauteile können gleichzeitig oder in einem weiteren Arbeitsschritt montiert werden.

Die Leiterplatte ist entweder starr oder flexibel ausgeführt. Eine starre Leiterplatte besteht im Wesentlichen aus einer gelochten Kunststoffplatte, wobei die verschiedenen elektrischen Bauteile bzw. Stanzgitter mit ihren elektrischen Kontakten in die Löcher eingesteckt und festgelötet oder festgeschweißt werden. Eine flexible Leiterplatte besteht aus einem hierfür geeigneten dauerhaft flexiblen Kunststoffmaterial.

Zur Verbesserung der elektrischen Kontaktierung wird zweckmäßigerweise eine Kontaktfläche des Stanzgitters mit einer zusätzlichen Beschichtung versehen, um beispielsweise die Kontaktierung mit einem vorstehend genannten beweglichen Kontaktschieber zu verbessern. Insbesondere ist für eine solche Beschichtung eine Silber-Nickel-20-Legierung, die dem Fachmann bekannt ist, geeignet. Das Aufbringen dieser Beschichtung ist bei einem dreidimensional ausgeformten Stanzgitter ohne Beschädigung der Leiterplatte möglich.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der Erfindung ist nur durch die Ansprüche definiert.

Die Erfindung wird im Folgenden anhand zweier Ausführungsbeispiele unter Bezugnahme auf die zugehörigen Zeichnungen näher erläutert. Es zeigt:
- Fig. 1: eine Leiterplatte aus dem Stand der Technik,
- Fig. 2: eine erfindungsgemäße Leiterplatte mit eingegossenem Stanzgitter und
- Fig. 3: eine Leiterplatte nach Fig. 2 in alternativer Ausgestaltung.

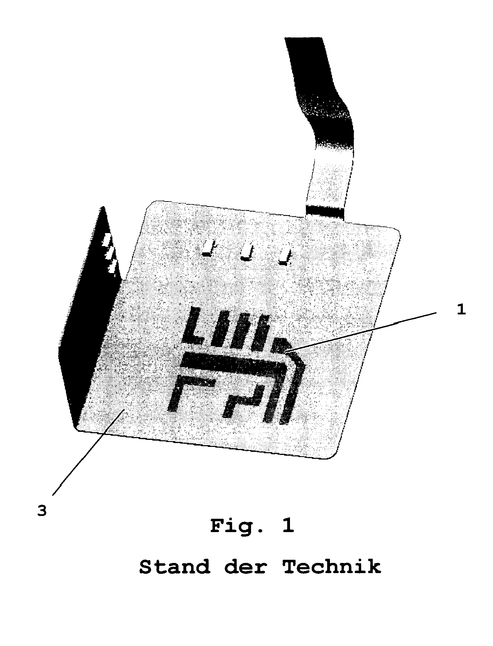

Die entweder starr oder flexibel ausgebildete Leiterplatte 3 nach Fig. 1 stellt eine an sich bekannte gedruckte Schaltung dar, bei der beispielsweise auf eine starre Kunststoffplatte verschiedene elektrische Bauteile, wie integrierte Schaltkreise, Kondensatoren und Widerstände, aufgesetzt und in üblicher Weise festgelötet oder festgeschweißt werden. An der Leiterplatte 3 ist ein Stanzgitter 1 zur Kontaktierung verschiedener elektrischer Bauteile vorgesehen, wobei durch die im Wesentlichen flächige Ausbildung des Stanzgitters 1 die Stromstärke der durch das Stanzgitter 1 hindurchfließenden Ströme begrenzt ist, da ansonsten eine thermische Beschädigung der Leiterplatte 3 durch die abfallende elektrische Leistung nicht zu vermeiden ist.

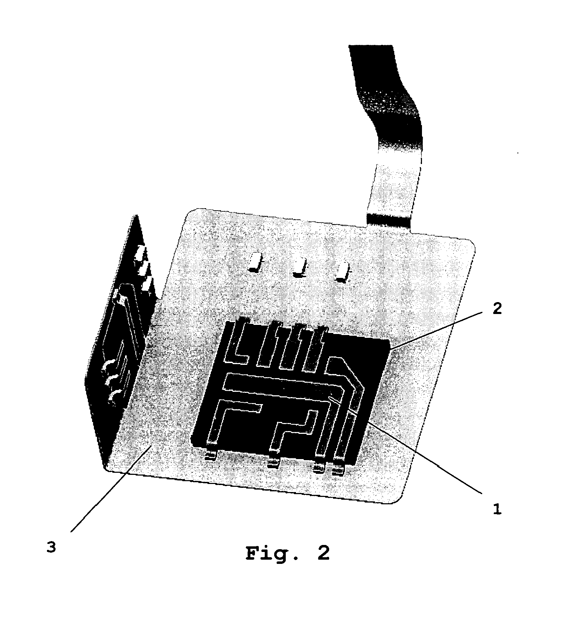

Gemäß Fig. 2 ist das Stanzgitter 1 in einen hierfür geeigneten Kunststoff 2 eingegossen und gehäuseartig bzw. dreidimensional ausgeformt, um das Hindurchfließen höherer Stromstärken zu ermöglichen. Insbesondere kann ein solches Stanzgitter 1 gemeinsam mit weiteren elektrischen Bauteilen 5 in einem einzigen Arbeitsgang an der Leiterplatte 3 angeordnet und festgelötet bzw. festgeschweißt werden, wodurch die Produktion einer solchen Leiterplatte 3 erheblich vereinfacht ist.

Weiterhin können an dem gehäuseartig ausgeformten Stanzgitter 1 weitere oberflächenmontierte elektrische Bauteile angeordnet werden, um diese u.a. thermisch von der Leiterplatte 3 zu isolieren.

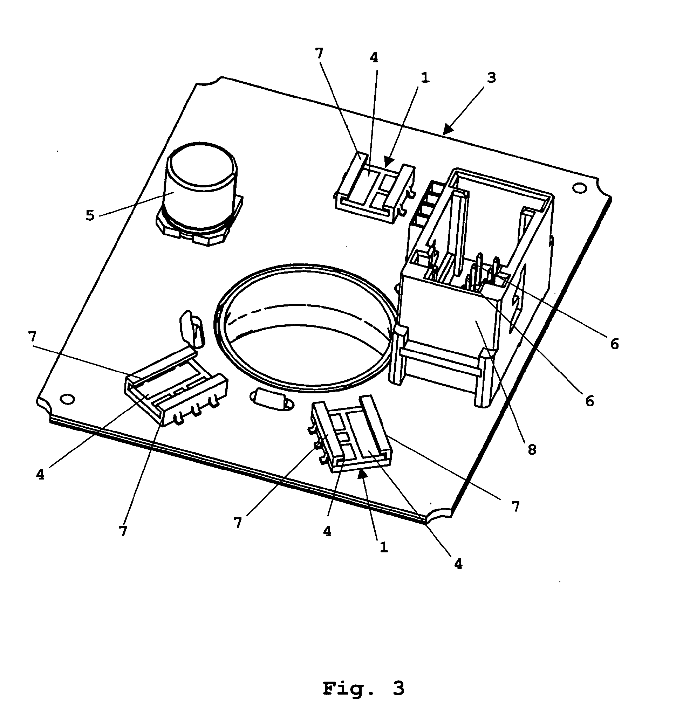

Nach Fig. 3 sind mehrere Stanzgitter 1 mit Kontaktflächen 4 und ein Stanzgitter 1 mit Kontaktstiften 6 mit einer ein elektrisches Bauteil 5 tragenden Leiterplatte 3 einstückig verbunden. Jedes Kontaktflächen 4 aufweisende Stanzgitter 1 ist beidseits durch einstückig mit der Leiterplatte 3 verbundene Führungselemente 7 aus einem Kunststoff zur verschiebbaren Lagerung eines Schiebeschaltgliedes verbunden, das mit seinen federnden Kontaktarmen die Kontaktflächen 4 beaufschlagt. Dem Stanzgitter 1 mit Kontaktstiften 6 ist ein Steckkragen 8 zugeordnet, der ebenso wie die Führungselemente 7 aus einem Kunststoff gefertigt ist.

## Patentansprüche

1. Leiterplatte zur Bestückung mit oberflächenmontierten Bauteilen, **dadurch gekennzeichnet, dass** an der Leiterplatte (3) ein von einem Kunststoff (2) ummanteltes und dreidimensional ausgeformtes Stanzgitter (1) angeordnet ist.

2. Leiterplatte nach Anspruch 1, **dadurch gekennzeichnet, dass** das Stanzgitter (1) gehäuseartig ausgebildet ist.

3. Leiterplatte nach Anspruch 1 oder 2, **dadurch gekennzeichnet, dass** an einer Oberfläche des Stanzgitters (1) eine Kontaktfläche ausgebildet ist.

4. Leiterplatte nach Anspruch 3, **dadurch gekennzeichnet, dass** die Kontaktfläche beschichtet ist.

5. Leiterplatte nach einem der Ansprüche 1 bis 4, **dadurch gekennzeichnet, dass** das Stanzgitter (1) mit Strömen hoher Stromstärke belastbar ist.

6. Leiterplatte nach einem der Ansprüche 1 bis 5, **dadurch gekennzeichnet, dass** das Stanzgitter (1) durch Führungselemente (7) für ein Schiebeschaltglied begrenzt ist.

7. Leiterplatte nach Anspruch 6, **dadurch gekennzeichnet, dass** den Führungselementen (7) insbesondere einstückig damit ausgebildete Rampen zugeordnet sind, die mit federnden Kontaktarmen zum Abheben und Aufsetzen auf Kontaktflächen (4) zusammenwirken.

8. Leiterplatte nach einem der Ansprüche 1 bis 5, **dadurch gekennzeichnet, dass** das Stanzgitter (1) in einem Steckkragen (8) angeordnete Kontaktstifte (6) trägt.

9. Leiterplatte nach Anspruch 6 oder 8, **dadurch gekennzeichnet, dass** die Führungselemente (7) und/oder der Steckkragen (8) aus Kunststoff gefertigt und einstückig mit der Leiterplatte (3) ausgebildet sind.

10. Leiterplatte nach einem der Ansprüche 1 bis 9, **dadurch gekennzeichnet, dass** am Stanzgitter (1) ein weiteres oberflächenmontiertes Bauteil befestigbar ist.

11. Leiterplatte nach einem der Ansprüche 1 bis 10, **dadurch gekennzeichnet, dass** die Leiterplatte (3) starr oder flexibel ausgebildet ist.

12. Verfahren zum Bestücken einer Leiterplatte (3), bei dem oberflächenmontierte Bauteile auf der Leiterplatte (3) befestigt werden, **dadurch gekennzeichnet, dass** ein Stanzgitter (1), das von einem Kunststoff (2) ummantelt und dreidimensional ausgeformt ist, gleichzeitig auf der Leiterplatte (3) befestigt wird.

13. Verfahren nach Anspruch 12, **dadurch gekennzeichnet, dass** für eine Kontaktfläche des Stanzgitters (1) eine Beschichtung vorgesehen wird, insbesondere eine Silber-Nickel-20-Legierung.

14. Verfahren nach Anspruch 12 oder 13, **dadurch gekennzeichnet, dass** an einer Kontaktfläche des Stanzgitters (1) ein weiteres oberflächenmontiertes Bauteil befestigt wird.

## Geänderte Patentansprüche

### Geänderte Patentansprüche gemäss Regel 137(2) EPÜ.

**1.** Leiterplatte zur Bestückung mit oberflächenmontierten Bauteilen, wobei an der Leiterplatte (3) ein von einem Kunststoff (2) ummanteltes und dreidimensional ausgeformtes Stanzgitter (1) angeordnet ist, **dadurch gekennzeichnet, dass** das Stanzgitter (1) durch Führungselemente (7) für ein Schiebeschaltglied begrenzt ist oder in einem aus Kunststoff gefertigten und einstückig mit der Leiterplatte (3) ausgebildeten Steckkragen (8) angeordnete Kontaktstifte (6) trägt.

**2.** Leiterplatte nach Anspruch 1, **dadurch gekennzeichnet, dass** das Stanzgitter (1) gehäuseartig ausgebildet ist.

**3.** Leiterplatte nach Anspruch 1 oder 2, **dadurch gekennzeichnet, dass** an einer Oberfläche des Stanzgitters (1) eine Kontaktfläche ausgebildet ist.

**4.** Leiterplatte nach Anspruch 3, **dadurch gekennzeichnet, dass** die Kontaktfläche beschichtet ist.

**5.** Leiterplatte nach einem der Ansprüche 1 bis 4, **dadurch gekennzeichnet, dass** das Stanzgitter (1) mit Strömen hoher Stromstärke belastbar ist.

**6.** Leiterplatte nach Anspruch 1, **dadurch gekennzeichnet, dass** den Führungselementen (7) insbesondere einstückig damit ausgebildete Rampen zugeordnet sind, die mit federnden Kontaktarmen zum Abheben und Aufsetzen auf Kontaktflächen (4) zusammenwirken.

**7.** Leiterplatte nach Anspruch 1 oder 6, **dadurch gekennzeichnet, dass** die Führungselemente (7) aus Kunststoff gefertigt und einstückig mit der Leiterplatte (3) ausgebildet sind.

**8.** Leiterplatte nach einem der Ansprüche 1 bis 9, **dadurch gekennzeichnet, dass** am Stanzgitter (1) ein weiteres o-berflächenmontiertes Bauteil befestigbar ist.

**9.** Leiterplatte nach einem der Ansprüche 1 bis 10, **dadurch gekennzeichnet, dass** die Leiterplatte (3) starr oder flexibel ausgebildet ist.
